(19) Europäisches Patentamt
European Patent Office
Office européen des brevets

(11) **EP 1 324 488 A2**

(12) **EUROPEAN PATENT APPLICATION**

(43) Date of publication:
**02.07.2003 Bulletin 2003/27**

(51) Int Cl.$^7$: **H03H 9/25**, H03H 9/64

(21) Application number: **02258612.7**

(22) Date of filing: **13.12.2002**

| | |
|---|---|
| (84) Designated Contracting States:<br>**AT BE BG CH CY CZ DE DK EE ES FI FR GB GR IE IT LI LU MC NL PT SE SI SK TR**<br>Designated Extension States:<br>**AL LT LV MK RO**<br><br>(30) Priority: **19.12.2001 JP 2001386317**<br><br>(71) Applicant: **ALPS ELECTRIC CO., LTD.**<br>**Ota-ku Tokyo 145 (JP)** | (72) Inventors:<br>• **Suzuki, Jin, c/o Alps Electric Co.,Ltd.**<br>**Tokyo (JP)**<br>• **Sato, Takashi, c/o Alps Electric Co.,Ltd.**<br>**Tokyo (JP)**<br>• **Ozaki, Kyosuke, c/o Alps Electric Co.Ltd.**<br>**Tokyo (JP)**<br><br>(74) Representative: **Kensett, John Hinton**<br>**Saunders & Dolleymore,**<br>**9 Rickmansworth Road**<br>**Watford, Hertfordshire WD18 0JU (GB)** |

(54) **Surface acoustic wave device**

(57) The electrode finger pitch of an interdigital transducer (IDT) (17) and the reflecting element pitch of grating reflectors (21,22) have the same value that is equal to 1/2 of the wavelength λ of a surface acoustic wave to be generated. The distance L between the ends of the interdigital transducer and the ends of the respective grating reflectors is given by

$$L = \{(5 \pm n)/8\}\lambda$$

where n is 0 or a multiple of 4 and L is a positive value.

# FIG. 1

EP 1 324 488 A2

**Description**

BACKGROUND OF THE INVENTION

1. Field of the Invention

The present invention relates to a surface acoustic wave device and a duplexer using it. In particular, the invention relates to a surface acoustic wave device suitable for use in an RF (radio frequency) filter, an antenna resonator, etc. of mobile communication equipment and a duplexer using such a surface acoustic wave device.

2. Description of the Related Art

Recent advancement of mobile communication equipment such as cellular phones and PHS phones is remarkable. Surface acoustic wave devices are widely employed in such equipment because they enable miniaturization and weight reduction. Surface acoustic wave devices are known as electromechanical conversion devices in which a surface acoustic wave (SAW) traveling close to the surface of an elastic body or the interface between elastic bodies is used for a frequency selection device in a transmission circuit.

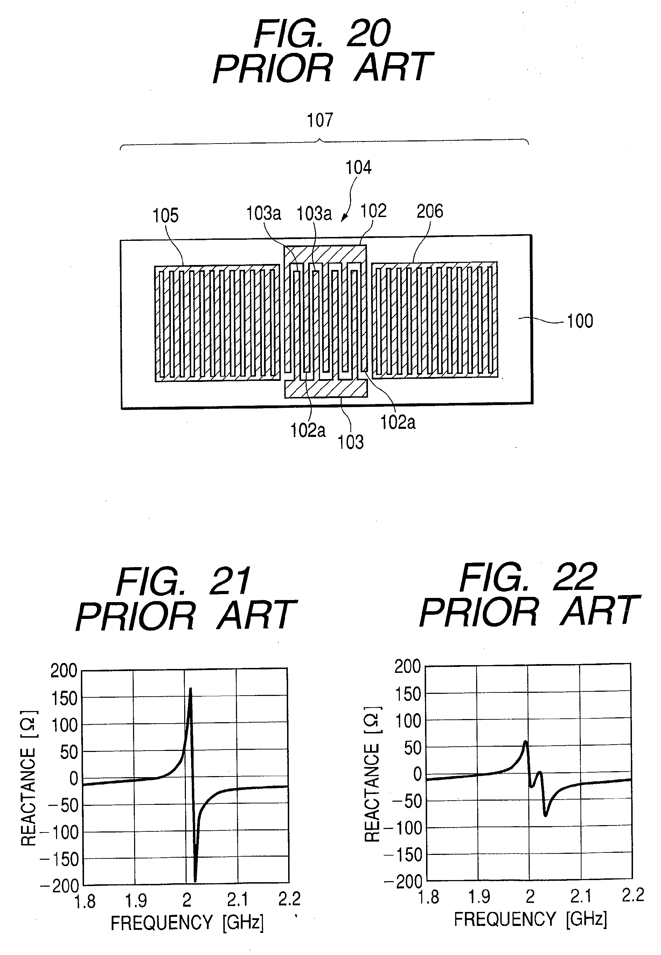

Fig. 20 is a plan view of a one-terminal-pair surface acoustic wave (SAW) filter that is a kind of conventional surface acoustic wave device. In the surface acoustic wave filter of this example, a pair of electrodes 102 and 103 of an interdigital transducer (IDT) 104 that functions as a converter for conversion between an electrical signal and a surface acoustic wave (SAW) are formed on the surface of a piezoelectric single crystal substrate 100 of lithium tantalate ($LiTaO_3$), lithium niobate ($LiNbO_3$), potassium niobate ($KNbO_3$), or the like so as to be opposed to each other. Grating reflectors 105 and 106 for forming a standing wave by causing multiple reflection of a generated surface acoustic wave are formed on both sides of the interdigital transducer 104. A SAW resonator 107 is thus formed.

In this surface acoustic wave filter, the resonance frequency f of the SAW resonator 107 is determined by the sound speed V of a surface acoustic wave traveling across the surface of the substrate 100 and the width and interval W of electrode fingers 102a of the electrode 102 and electrode fingers 103a of the electrode 103. In general, the resonance frequency f is given by the following Equation (1):

$$f = V/\lambda = V/4W \tag{1}$$

where $\lambda$ is the wavelength of a generated surface acoustic wave.

It is understood from Equation (1) that the resonance frequency f increases and hence use in a higher frequency band is enabled as the electrode finger width and interval W decreases or the sound speed V increases.

Fig. 21 shows an ideal frequency-reactance curve of a surface acoustic wave resonator for a 2-GHz band. As shown in Fig. 21, ideally, the reactance curve should be such that the sharpness (Q) of the resonance waveform is high and the waveform has no disorder in a 2-GHz frequency band used.

However, this type of surface acoustic wave resonator is associated with various loss factors, examples of which are a transmission loss that is caused by a phenomenon that a surface acoustic wave is not reflected completely by the grating reflectors and partially passes those to go outside, an inherent loss due to viscosity of the substrate material, a scattering loss due to propagation disorder that is caused by the fact that the substrate surface and its vicinity do not provide an ideal surface, a diffraction loss that is caused by a phenomenon that a surface acoustic wave expands so as to assume a beam-like form as it travels, and an ohmic loss due to the electric resistances of the metal electrodes that constitute the IDT and the grating reflectors. Furthermore, the additional mass effect of the electrodes is not negligible in the high frequency band of 2 GHz. As a result, as shown in Fig. 22, a problem arises that the waveform tends to have a large ripple-like spurious component R. That is, the waveform itself is less sharp, the amplitude is small, and the Q factor is also small.

SUMMARY OF THE INVENTION

The present invention has been made in view of the above circumstances, and an object of the invention is therefore to provide a surface acoustic wave device that can be used in a high frequency band of 2 GHz, for example, and makes it possible to place a spurious frequency band out of a resonance frequency band to thereby provide a resonance waveform that is high in sharpness, as well as to a duplexer using such a surface acoustic wave device.

The invention provides a surface acoustic wave device comprising a piezoelectric body; an interdigital transducer provided on the piezoelectric body; and grating reflectors provided on both sides of the interdigital transducer, each of the grating reflectors having a plurality of reflecting elements that are arranged at prescribed intervals and have the same pitch as an electrode finger pitch of the interdigital transducer, the same pitch being 1/2 of a wavelength λ of a surface acoustic wave to be generated, wherein a distance L between ends of the interdigital transducer and ends of the respective grating reflectors is given by:

$$L = \{(5 \pm n)/8\}\lambda$$

where n is 0 or a multiple of 4 and L is a positive value.

Setting the relationship between the resonance wavelength λ and the distance L between the ends of the interdigital transducer and the ends of the respective grating reflectors so that the above equation is satisfied makes it possible to lower the level of a spurious component and cause the spurious frequency to go away from the resonance frequency and its vicinity, which makes it easier to provide a characteristic having a large Q factor. Therefore, a sharp attenuation curve having large attenuation outside a target band can be obtained.

The piezoelectric body may be made of $LiTaO_3$. This makes it easier to provide a surface acoustic wave device that, even in a 2-GHz band, has only a small loss and is low in the level of a spurious component and high in the sharpness of a resonance waveform (the Q factor is large), and in which the spurious frequency is distant from the resonance frequency.

The piezoelectric body may have orientation that is given by rotation of 38° to 44° about the X axis from the Y axis in a $LiTaO_3$ single crystal. This makes it easier to reliably provide a surface acoustic wave device that, even in a 2-GHz band, has only a small loss and is low in the level of a spurious component and high in the sharpness of a resonance waveform (the Q factor is large), and in which the spurious frequency is distant from the resonance frequency.

The normalized film thickness H/λ of the interdigital transducer and the reflecting elements may be in a range of 0.02 to 0.15 (preferably, 0.02 to 0.10), where H is the film thickness of the interdigital transducer and the reflecting elements. This makes it easier to reliably provide a surface acoustic wave device that, even in a 2-GHz band, has only a small loss and is low in the level of a spurious component and high in the sharpness of a resonance waveform (the Q factor is large), and in which the spurious frequency is distant from the resonance frequency.

The invention also provides a duplexer for a 2-GHz band comprising any of the above surface acoustic wave devices. In this duplexer, even in a 2-GHz band, the influence of a spurious component is small a resonance waveform is very sharp (the Q factor is large), and a sharp attenuation characteristic with large attenuation is obtained.

Embodiments of the present invention will now be described, by way of example, with reference to the accompanying drawings, in which:

Fig. 1 is a plan view of a surface acoustic wave device according to a first embodiment of the present invention;
Fig. 2 is a partial sectional view of the surface acoustic wave device taken along line A-A in Fig. 1;
Fig. 3 illustrates crystal orientation of a piezoelectric substrate suitable for use in the surface acoustic wave device of Fig. 1;
Fig. 4 shows an electrode finger pitch of an interdigital transducer, a reflecting element pitch of each grating reflector, and an interval L between the interdigital transducer and each grating reflector in the surface acoustic wave device of Fig. 1;
Fig. 5 shows an equivalent circuit of the surface acoustic wave device of Fig. 1;
Figs. 6 and 7 show exemplary ladder-type SAW filter devices to which the surface acoustic wave device of Fig. 1 is applied;
Fig. 8 is a graph showing an ideal attenuation waveform of the ladder-type SAW filter device of Fig. 6 and disordered portions due to a spurious component;
Fig. 9 is a circuit diagram showing an exemplary circuit configuration of a cellular phone to which the surface acoustic wave device of Fig. 1 can be applied;
Figs. 10-18 are graphs showing reactance curves of surface acoustic wave devices in which L was set to 9λ/8, 5λ/8, 1λ/8, 2λ/8, 3λ/8, 4λ/8, 6λ/8, 7λ/8, and 8λ/8, respectively;
Fig. 19 is a graph showing a relationship among the distance L between the interdigital transducer and the reflectors, the electrode film thickness, the resonance frequency, and the spurious frequency in each of the surface acoustic wave devices of Figs. 10-18;
Fig. 20 is a plan view of an exemplary conventional surface acoustic wave device;
Fig. 21 is a graph showing an ideal reactance curve to be obtained by a conventional surface acoustic wave device; and
Fig. 22 is a graph showing a reactance curve of a conventional surface acoustic wave device that includes a spurious component.

DESCRIPTION OF THE PREFERRED EMBODIMENTS

Naturally, the invention is not limited to the embodiments described below. In the drawings to be referred to below, for the sake of convenience of drawing, the scale varies component by component.

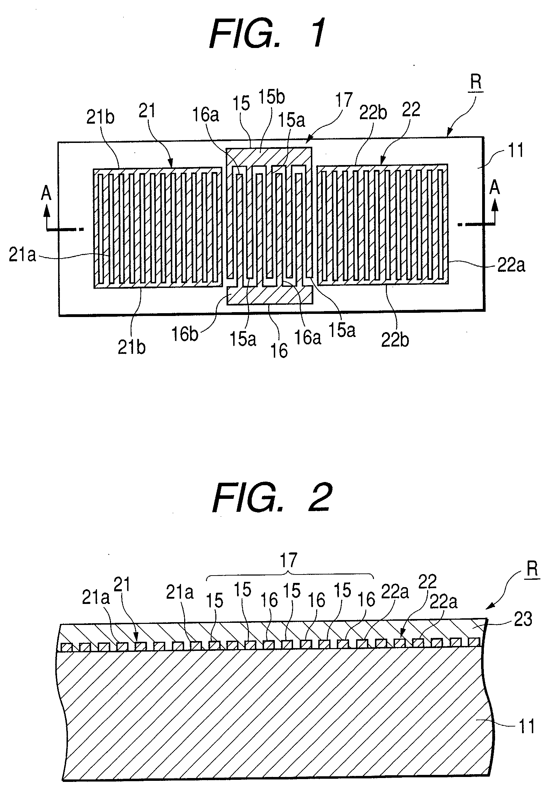

Fig. 1 is a plan view of a one-terminal-pair surface acoustic wave (SAW) resonator that is a surface acoustic wave device according to a first embodiment of the invention. Fig. 2 is a partial sectional view taken along line A-A in Fig. 1. The SAW resonator R according to this embodiment is provided with a substrate 11 made of a piezoelectric material such as $LiTaO_3$, an interdigital transducer (IDT) 17 located at the center of the surface of the substrate 11, and grating reflectors 21 and 22 that are formed on both sides of the interdigital transducer 17. The interdigital transducer 17 is formed by a pair of electrodes (electrode layers) 15 and 16 that are opposed to each other, and functions as a converter for conversion between an electrical signal and a surface acoustic wave (SAW).

The grating reflectors 21 and 22, which serve to form a standing wave by causing multiple reflection of a generated surface acoustic wave, are formed at positions that are symmetrical with respect to the interdigital transducer 17. Although omitted in Fig. 1, a protective layer 23 made of silicon dioxide ($SiO_2$) is formed so as to cover the interdigital transducer 17, the grating reflectors 21 and 22, and the top surface of the substrate 11 (see Fig. 2).

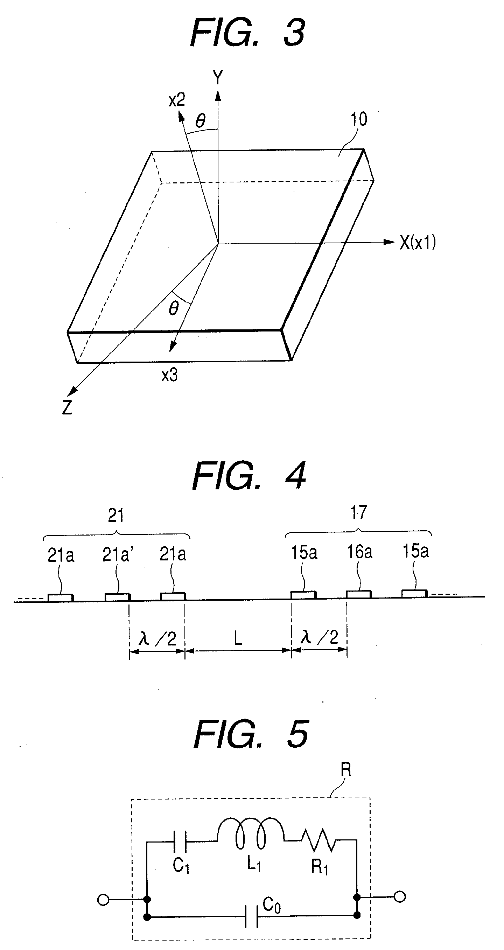

For example, as shown in Fig. 3, the substrate 11 is a substrate 10 obtained by cutting a piezoelectric single crystal such as $LiTaO_3$ having crystallographic axes X, Y, and Z so that the substrate 10 has orientation given by rotation of an angle θ about the axis X from the Y axis toward the Z axis. In this specification, such a piezoelectric single crystal substrate 10 is called a θY-X substrate (or a substrate having face orientation θY and a propagation direction X). Using the piezoelectric single crystal substrate 10 as the substrate 11 is preferable for use in a high frequency band such as a 2-GHz band.

In view of an insertion loss of a resonator that is formed on a θY-X substrate, general SAW resonators using such a $LiTaO_3$ single crystal substrate use a 36°Y-X substrate (in other words, a substrate having face orientation 36°Y and a propagation direction X). This is because the 36°Y-X substrate has a minimum propagation loss for a surface acoustic wave having a relatively long wavelength for which the additional mass effect of electrodes formed on the substrate surface is negligible. However, in a short wavelength range such as bands of 1 to 2 GHz, the thickness of electrodes can no longer be disregarded with respect to the wavelength of a generated surface acoustic wave and the additional mass effect of electrodes takes effect. Therefore, for GHz bands such as a 2-GHz band, it is preferable to use a 42°Y-X substrate rather than the above 36°Y-X substrate.

Among other various usable piezoelectric substrates are LSAW (leaky SAW) substrates such as a quartz substrate having face orientation 15.7°Y and a propagation direction X, a $LiNbO_3$ substrate having face orientation 41°Y and a propagation direction X, a $LiNbO_3$ substrate having face orientation 64°Y and a propagation direction X, and a $Li_2B_4O_3$ substrate having face orientation 47.3°Z and a propagation direction 90°X.

In this embodiment, it is preferable that the substrate 11 be a 42°Y-X substrate in its entirely. However, rather than such a monolithic substrate, a composite substrate may naturally be used in which the top surface of a common non-piezoelectric substrate such as a Si substrate is coated with a hard layer such as a diamond layer for increasing the propagation speed and a $LiTaO_3$ piezoelectric layer having the crystal orientation of the above 42°Y-X substrate is formed on the hard layer. Naturally, the $LiTaO_3$ piezoelectric layer may be replaced by any of various piezoelectric layers known as LSAW (leaky SAW) layers substrates such as a quartz layer having face orientation 15.7°Y and a propagation direction X, a $LiNbO_3$ layer having face orientation 41°Y and a propagation direction X, a $LiNbO_3$ layer having face orientation 64°Y and a propagation direction X, and a $Li_2B_4O_3$ layer having face orientation 47.3°Z and a propagation direction 90°X.

To assume a comb shape, the electrode 15 is composed of a plurality of strip-like electrode fingers 15a that are arranged at prescribed intervals and a band-like terminal portion 15b that extends perpendicularly to the electrode fingers 15a to connect those. Similarly, the electrode 16 is composed of a plurality of strip-like electrode fingers 16a and a band-like terminal portion 16b that connects the electrode fingers 16a.

The interdigital transducer (IDT) 17 is formed by opposing the electrodes 15 and 16 to each other in such a manner that the terminal portions 15b and 16b are located adjacent to the longer sides of the substrate 11 and that the electrode fingers 15a and the electrode fingers 16a are arranged alternately at prescribed intervals so as not to contact each other. The electrodes 15 and 16 are highly conductive metal thin films of Pt, Au, Ag, Pd, Ni, Al, Cu, an Al-Cu alloy, or the like.

The grating reflector 21 is composed of a plurality of reflecting elements 21a that are arranged in grating form and connecting portions 21b that connects the reflecting elements 21a. Similarly, the grating reflector 22 is composed of a plurality of band-like reflection elements 22a and connecting portions 22b that extend perpendicularly to the reflection elements 22a to connect those. The grating reflectors 21 and 22 are metal thin films of Pt, Au, Ag, Pd, Ni, Al, Cu, or the like or dielectric thin films. Alternatively, grating reflectors may be formed by forming, as reflecting elements, a plurality of long and narrow grooves in the substrate 11 in areas where to form the strip-like electrode fingers 15a and 16a in the case of the grating reflectors 21 and 22.

In the SAW resonator R according to this embodiment, as shown in Fig. 4, the pitch of the reflecting elements 21a of the grating reflector 21 is set to 1/2 of the wavelength $\lambda$ of a surface acoustic wave to be generated. The pitch of the reflecting elements 22a of the grating reflector 22 is also set to 1/2 of the wavelength $\lambda$ of a surface acoustic wave to be generated. By arranging the reflecting elements 21a and the reflecting elements 22a at the pitch that is equal to 1/2 of the wavelength $\lambda$, a large reflection coefficient can be obtained at a Bragg frequency by virtue of an accumulation effect. The pitch of the reflecting elements 21a that are arranged as shown in Fig. 4 is a distance from a longer side of one reflecting element 21a to the corresponding longer side of an adjacent reflecting element 21a. The pitch of the electrode fingers 15a and 16a that are arranged alternately (15a, 16a, 15a, ...) as shown in Fig. 4 is a distance from a longer side of one electrode finger 15a or 16a to the corresponding longer side of an adjacent electrode finger 16a or 15a.

Further, in the structure according to this embodiment, the interval L between the left-end electrode finger 15a of the interdigital transducer (IDT) 17 and the adjacent, right-end reflecting element 21a of the grating reflector 21 (see Fig. 4) is set so as to satisfy the following Equation (2):

$$L = \{(5 \pm n)/8\}\lambda \tag{2}$$

where n is 0 or a multiple of 4 and Equation (2) has a positive value.

For example, according to Equation (2), L is set to $(5/8)\lambda$ when n is equal to 0. L is set to $(9/8)\lambda$ or $(1/8)\lambda$ when n is equal to 4. L is set to $(13/8)\lambda$ when n is equal to 8.

The interval L between the right-end electrode finger 15a of the interdigital transducer 17 and the adjacent, left-end strip portion 22a of the grating reflector 22 is also set so as to satisfy Equation (2). For example, according to Equation (2), L is set to $(5/8)\lambda$ when n is equal to 0. L is set to $(9/8)\lambda$ or $(1/8)\lambda$ when n is equal to 4. L is set to $(13/8)\lambda$ when n is equal to 8.

The reason why the interval L between the interdigital transducer 17 and the grating reflectors 21 and 22 which are disposed on both sides of the interdigital transducer 17 is determined according to Equation (2) is to obtain a sharp resonance characteristic that is free of a spurious component (described later).

Let H represent the film thickness of the interdigital transducer 17 and the grating reflectors 21 and 22; then, it is preferable that the normalized film thickness $H/\lambda$ of the interdigital transducer 17 and the grating reflectors 21 and 22 be in a range of 0.02 to 0.10. It is preferable that the film thickness of the interdigital transducer 17 and the grating reflectors 21 and 22 be 0.05 to 0.15 $\mu$m.

In operation in GHz bands and their vicinities, the thickness of the electrodes is not negligible with respect to the wavelength of a generated surface acoustic wave and significant influence of the additional mass effect of the electrodes appears. For example, if the thickness of the electrodes is increased, the electromechanical coupling coefficient increases and the pass bandwidth of the SAW filter increases. However, problems arise that a spurious component occurs and the propagation loss of a surface acoustic wave increases. Conversely, if the thickness of the electrodes is small, there exists a problem that a spurious component due to a bulk wave occur within the pass band of the SAW filter. If feasibility of processes of film formation etc. is taken into consideration, the range $H/\lambda = 0.02$ to 0.10 is proper.

Fig. 5 shows an equivalent circuit of the SAW resonator R according to this embodiment. An equivalent parallel capacitance $C_0$ is a capacitance corresponding to a case that the resonator operates merely as a capacitor. An equivalent series inductance $L_1$ and an equivalent series capacitance $C_1$ are equivalent constants corresponding to a case that the resonator operates as an electromechanical oscillation system. An equivalent series resistance R1 represents various losses of the resonator.

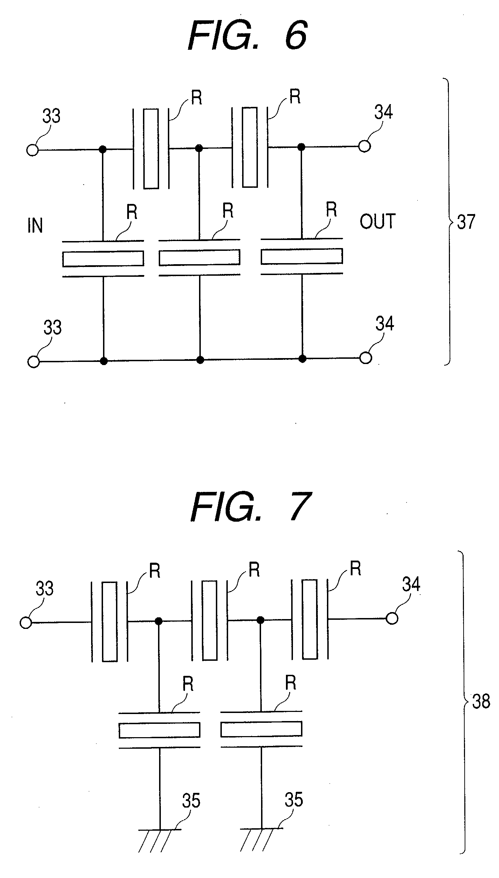

Fig. 6 shows an exemplary ladder-type SAW filter device using **SAW** resonators R according to this embodiment. In this ladder-type **SAW** filter device 37, two one-terminal-pair **SAW** resonators R are connected to each other in series, another one-terminal-pair SAW resonator R is connected to the connecting point of the above two SAW resonators R, and two other one-terminal-pair SAW resonators R are provided at the input and output sides (the latter three SAW resonators R are parallel with each other). All the SAW resonators R have the same structure. One terminals 33 are input terminals (IN) and the other terminals 34 are output terminals (OUT).

Fig. 7 shows another exemplary ladder-type SAW filter device using SAW resonators R according to this embodiment. In this ladder-type SAW filter device 38, three one-terminal-pair SAW resonators R are connected to each other in series and one terminals of two other one-terminal-pair SAW resonators R are connected to the respective connecting points of the above three SAW resonators R (the two SAW resonators R are parallel with each other). All the SAW resonators R have the same structure. The other terminals of the two parallel SAW resonators R are grounded. One terminal 33 of the series connection of the three SAW resonators R is an input terminal (IN) and the other terminal 34 is an output terminal (OUT).

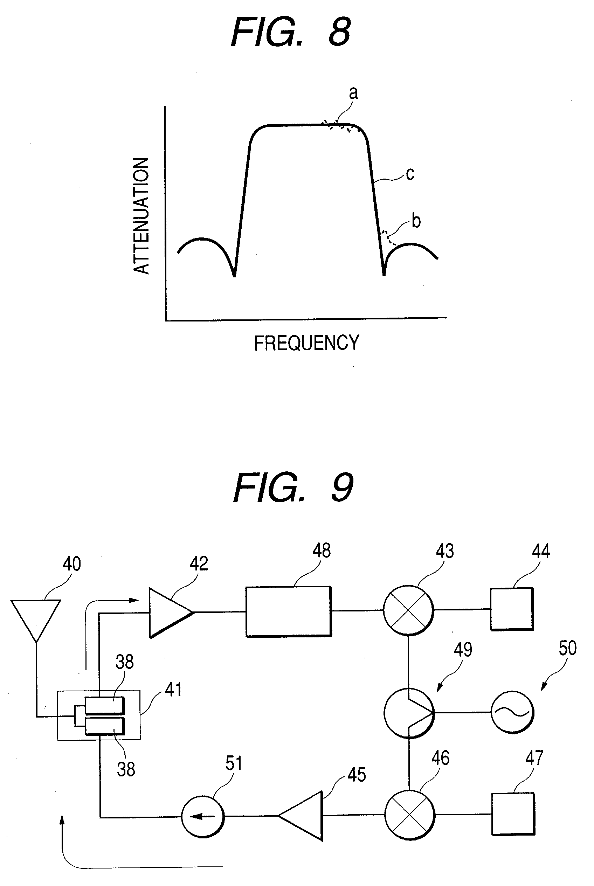

Fig. 8 shows an ideal pass band characteristic to be obtained by the exemplary ladder-type SAW filter device of Fig. 7. AS long as the ideal attenuation characteristic of Fig. 8 is attained, a superior filter device can be obtained that provides large attenuation outside the pass band.

However, in the case of an ordinary SAW filter device, disordered portions (indicated by chain lines a and b in Fig. 8) occur on the ideal attenuation characteristic (indicated by a solid line c in Fig. 8). This is caused by disorder (spurious component) occurring on the reactance curve of the SAW resonator.

To prevent such a spurious component, it is preferable to determine the interval L between the interdigital transducer (IDT) 17 and the grating reflectors 21 and 22 that are disposed on both sides of the interdigital transducer 17 according to Equation (2) that was described in the above embodiment. As a result, a resonance characteristic that is free of a spurious component can be obtained.

Setting the relationship between the distance L and the resonance wavelength $\lambda$ so that Equation (2) is satisfied makes it possible to lower the level of a spurious component and cause the spurious frequency to go away from the resonance frequency and its vicinity, which makes it easier to provide a resonance waveform that is high in sharpness, that is, a characteristic having a large Q factor. Therefore, a sharp attenuation curve having large attenuation outside the target band can be obtained.

Fig. 9 shows an exemplary circuit configuration of a cellular phone to which the above-described SAW filter device is applied. In this exemplary circuit configuration, a duplexer 41 is connected to an antenna 40. An IF circuit 44 is connected to the output side of the duplexer 41 via a low-noise amplifier 42, and inter-stage filter 48, and a mixing circuit 43. An IF circuit 47 is connected to the input side of the duplexer 41 via an isolator 51, a power amplifier 45, and a mixing circuit 46. A local oscillator 50 is connected to the mixing circuits 43 and 46 via a distribution transformer 49.

'For example, the duplexer 41 incorporates two ladder-type SAW filter devices 38 (described above). The input terminals of the ladder-type SAW filter devices 38 are connected to the antenna 40. The output terminal of one ladder-type SAW filter device 38 is connected to the low-noise amplifier 42, and the output terminal of the other ladder-type SAW filter device 38 is connected to the isolator 51.

The cellular phone having the above configuration can employ, for signal switching in selecting a signal that is input from the antenna 40, the duplexer 41 incorporating two ladder-type SAW filter devices 38 (described above).

The SAW filter device according to the above embodiment exhibits a steep signal attenuation characteristic in a 2-GHz band such as 1.8 to 1.9 GHz and hence can provide a sharp filter characteristic that is free of a spurious component and has a large attenuation factor. Therefore, it can be applied to cellular phones that are used in a 2 GHz band.

On the other hand, in cellular phones that are used in the above band, assume that, for example, a band having a width of 60 MHz and centered at 1.88 GHz is used for one of transmission and reception and a band having a width of 60 MHz and centered at 1.96 GHz is used for the other. In this case, the band for transmission and the band for reception are separated from each other by only 20 MHz; a filter characteristic that is free of a spurious component is required. The use of the SAW filter device according to the above embodiment can easily provide a stable transmission/reception state with little fear that interference, noise, or the like may occur in a boundary range between the band for transmission and the band for reception. Example

A SAW resonator having an interdigital transducer was formed on the surface of a substrate being a $LiNbO_3$ single crystal and having crystal orientation 42°Y-X substrate.

The interdigital transducer was made of a Cu alloy and had a film thickness of 600 Å, and the width and the pitch of the electrode fingers of the interdigital transducer were set at 0.5 µm and 1.0 µm, respectively. Reactance curves in the vicinity of a frequency 2 GHz were determined when the interval L between the interdigital transducer and the grating reflectors was varied from $1\lambda/8$ to $10\lambda/8$. The film thickness of the grating reflectors was set equal to that of the interdigital transducer.

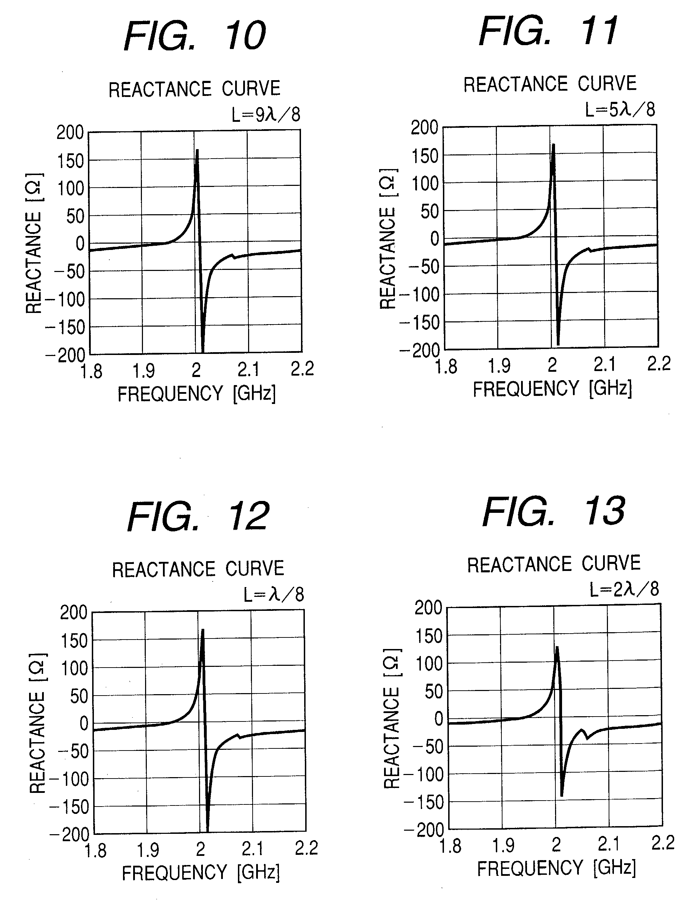

Figs. 10-18 show reactance curves that were obtained when L was set to $9\lambda/8$, $5\lambda/8$, $\lambda/8$, $2\lambda/8$, $3\lambda/8$, $4\lambda/8$, $6\lambda/8$, $7\lambda/8$, and $8\lambda/8$, respectively.

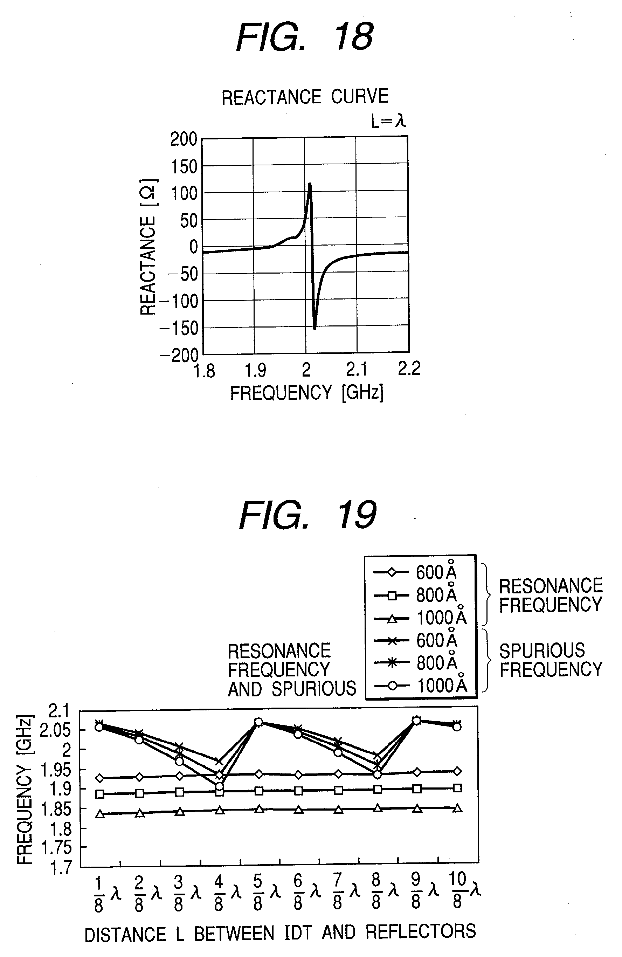

Frequencies of spurious components in the respective reactance curves of Figs. 10-18 and resonance frequencies of the respective reactance curves were determined. Results are shown in Table 1 and Fig. 19. Table 1 and Fig. 19 show measurement values in cases that the film thickness of the electrode fingers and the reflecting elements was equal to 800 Å and 1,000 Å in addition to 600 Å.

Table 1

| Sample No. | L value | Resonance frequency (film thickness: 600 Å) | Resonance frequency (film thickness: 800 Å) | Resonance frequency (film thickness: 1,000 Å) | Spurious frequency (film thickness: 600 Å) | Spurious frequency (film thickness: 800 Å) | Spurious frequency (film thickness: 1,000 Å) |
|---|---|---|---|---|---|---|---|
| 1 | 1λ/8 | 1.93025 | 1.887 | 1.84075 | 2.006 | 2.06 | 2.058 |
| 2 | 2λ/8 | 1.92975 | 1.88675 | 1.84175 | 2.0425 | 2.03225 | 2.024 |
| 3 | 3λ/8 | 1.93125 | 1.888 | 1.843 | 2.006 | 1.98675 | 1.96625 |
| 4 | 4λ/8 | 1.9325 | 1.88925 | 1.84375 | 1.9655 | 1.93425 | 1.90275 |
| 5 | 5λ/8 | 1.9335 | 1.88875 | 1.84525 | 2.067 | 2.06425 | 2.06475 |
| 6 | 6λ/8 | 1.93025 | 1.88875 | 1.8415 | 2.0485 | 2.04225 | 2.0325 |
| 7 | 7λ/8 | 1.9305 | 1.88875 | 1.84275 | 2.01525 | 2.001 | 1.98625 |
| 8 | 8λ/8 | 1.93225 | 1.88925 | 1.84375 | 1.9765 | 1.9525 | 1.92775 |
| 9 | 9λ/8 | 1.9335 | 1.89025 | 1.8445 | 2.0685 | 2.0675 | 2.0645 |
| 10 | 10λ/8 | 1.9345 | 1.89075 | 1.84525 | 2.05275 | 2.04825 | 2.04625 |

It is seen from the results of Table 1 and Figs. 10-19 that the spurious frequency is very distant from the resonance frequency when L was set to λ/8 (Fig. 12), 5λ/8 (Fig. 11), or 9λ/8 (Fig. 10). Even if a spurious component occurs at a low level, it is hardly a serious problem relating to the use of the resonator as long as the spurious frequency is very distant from the resonance frequency.

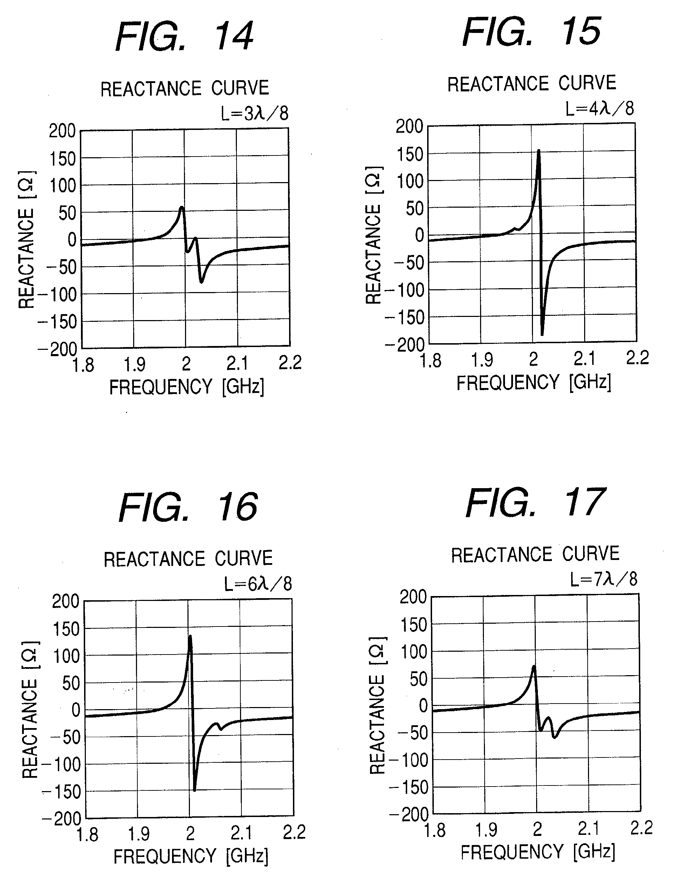

In contrast, in the cases of L = 2λ/8 (Fig. 13) and L = 6λ/8 (Fig. 16), the peak values of each reactance curve are small and each resonance waveform is low in sharpness. In the cases of L = 3λ/8 (Fig. 14) and L = 7λ/8 (Fig. 17), the spurious frequency is close to the resonance frequency and the peak values of each reactance curve are very small. The sharpness of each resonance waveform is very low and large Waveform distortion is caused by the spurious component. Further, in the case of L = 4λ/8 (Fig. 15), the spurious component is located close to the resonance frequency and hence a signal waveform may contain a ripple. In the case of L = 8λ/8 (Fig. 18), the spurious component is located close to the resonance frequency, whereby the peak values of the reactance curve are small and the sharpness of the resonance waveform is low.

The above measurement results show that in the cases of L = λ/8, 5λ/8, and 9λ/8 the spurious frequency is very distant from the resonance frequency and the influence of the spurious component is small. It is seen form the relationship of Fig. 19 that the spurious frequencies have periodicity. Therefore, it is apparent that L can be given a value with which the influence of a spurious component is small by setting L so that it satisfies Equation (2), that is, L = {(5 ± n)/8}λ, where n is 0 or a multiple of 4 and Equation (2) has a positive value.

However, in the case of L = λ/8, L needs to be set at about 0.25 μm because the resonance frequency should be within a 2-GHz band. Further, in view of the precision of current general photolithography processes, it is difficult to correctly control L to such a value in mass-production. In contrast, in the case of L = 5λ/8, the interval L amounts to about 1 μm and can reliably be controlled to such a value in mass-production; the SAW resonator can be mass-produced even with the precision of the current general photolithography processes. It is concluded that, in view of the precision of mass-production, practically, among L values that satisfy Equation (2) ones greater than or equal to 5λ/8 are preferable.

As described above, according to the invention, setting the relationship between the resonance wavelength λ and the distance L between the ends of the interdigital transducer and the ends of the respective grating reflectors so that the equation L = {(5 ± n)/8}λ is satisfied makes it possible to lower the level of a spurious component of the surface acoustic wave device. Even if a spurious component occurs, the spurious frequency can be made distant from the resonance frequency and its vicinity. These make it easier to provide a characteristic in which the Q factor that represents the sharpness of a resonance waveform is large. Therefore, a surface acoustic wave device that exhibits a sharp attenuation curve having large attenuation outside a target band can be obtained.

The piezoelectric body may be made of $LiTaO_3$. This makes it easier to provide a surface acoustic wave device that, even in a 2-GHz band, has only a small loss and is low in the level of a spurious component and high in the sharpness of a resonance waveform (the Q factor is large), and in which the spurious frequency is distant from the resonance frequency.

The piezoelectric body may have orientation that is given by rotation of 38° to 44° about the X axis from the Y axis in a LiTaO$_3$ single crystal. This makes it easier to reliably provide a surface acoustic wave device that, even in a 2-GHz band, has only a small loss and is low in the level of a spurious component and high in the sharpness of a resonance waveform (the Q factor is large), and in which the spurious frequency is distant from the resonance frequency.

The normalized film thickness H/λ of the interdigital transducer and the reflecting elements may be in a range of 0.02 to 0.10, where H is the film thickness of the interdigital transducer and the reflecting elements. This makes it easier to reliably provide a SAW filter that has only a small propagation loss and is low in the level of a spurious component. Further, the lift-off method can easily be used in the interdigital transducer formation process, which means an advantage that Cu alloy electrode materials, which cannot be used in dry etching, can easily be used.

**Claims**

1. A surface acoustic wave device comprising:

   a piezoelectric body;
   an interdigital transducer provided on the piezoelectric body; and
   grating reflectors provided on both sides of the interdigital transducer, each of the grating reflectors having a plurality of reflecting elements that are arranged at prescribed intervals and have the same pitch as an electrode finger pitch of the interdigital transducer, the same pitch being 1/2 of a wavelength λ of a surface acoustic wave to be generated,

   wherein a distance L between ends of the interdigital transducer and ends of the respective grating reflectors is given by

   $$L = \{(5 \pm n)/8\}\lambda$$

   where n is 0 or a multiple of 4 and L is a positive value.

2. The surface acoustic wave device according to claim 1, wherein the piezoelectric body is made of LiTaO$_3$.

3. The surface acoustic wave device according to claim 2, wherein the piezoelectric body has orientation that is given by rotation of 40° to 44° about an X axis from a Y axis in a LiTaO$_3$ single crystal.

4. The surface acoustic wave device according to claim 1, wherein a normalized film thickness H/λ of the interdigital transducer and the reflecting elements is in a range of 0.02 to 0.15, where H is a film thickness of the interdigital transducer and the reflecting elements.

5. A duplexer for a 2-GHz band, comprising the surface acoustic wave device according to claim 1.

# FIG. 1

# FIG. 2

## FIG. 3

## FIG. 4

## FIG. 5

# FIG. 6

# FIG. 7

# FIG. 8

# FIG. 9

## FIG. 10

REACTANCE CURVE

L=9λ/8

## FIG. 11

REACTANCE CURVE

L=5λ/8

## FIG. 12

REACTANCE CURVE

L=λ/8

## FIG. 13

REACTANCE CURVE

L=2λ/8

# FIG. 14

REACTANCE CURVE

L=3λ/8

# FIG. 15

REACTANCE CURVE

L=4λ/8

# FIG. 16

REACTANCE CURVE

L=6λ/8

# FIG. 17

REACTANCE CURVE

L=7λ/8

# FIG. 18

## REACTANCE CURVE

L=λ

# FIG. 19

DISTANCE L BETWEEN IDT AND REFLECTORS

# FIG. 20
## PRIOR ART

# FIG. 21
## PRIOR ART

# FIG. 22
## PRIOR ART